Europäisches Patentamt

**European Patent Office**

**Office européen des brevets**

(11) Publication number: **0 118 623**

**A1**

(12) **EUROPEAN PATENT APPLICATION**

(21) Application number: **83113218.8**

(22) Date of filing: **29.12.83**

(51) Int. Cl.³: **G 03 F 1/00**

(30) Priority: **14.02.83 US 466264**

(43) Date of publication of application:
**19.09.84 Bulletin 84/38**

(84) Designated Contracting States:
**DE FR GB NL**

(71) Applicant: **THE PERKIN-ELMER CORPORATION**
**Main Avenue**
**Norwalk Connecticut 06856(US)**

(72) Inventor: **Buckley, W. Derek**
**85 Delaware Road**
**Easton Connecticut 06615(US)**

(74) Representative: **Patentanwälte Grünecker, Dr.**
**Kinkeldey, Dr. Stockmair, Dr. Schumann, Jakob, Dr.**
**Bezold, Meister, Hilgers, Dr. Meyer-Plath**
**Maximilianstrasse 58**
**D-8000 München 22(DE)**

(54) **Pellicle cover for photomask.**

(57) In a projecting printing system for forming an image on a radiation sensitive wafer, which system includes a mask having a transparent substrate with a pattern of opaque and transparent areas formed on the surface thereof, an illumination system for directing radiation through the mask to the radiation sensitive wafer, an optical system for forming a focused image of a mask pattern on the wafer, the improvement comprising a pellicle cover assembly for maintaining the images of any contaminate particles on the surface of the mask out of focus, said pellicle cover being fabricated from polymethylmethacrylate.

FIG.1

EP 0 118 623 A1

PATENTANWÄLTE
GRÜNECKER · KINKELDEY · DR STOCKMAIR
DR.OCH... SCH · JAMES · DR. BEZOLD · MEISTER
HILGERS · DR. MEYER · PLATH

0118623

## PELLICLE COVER FOR PHOTOMASK

### Field of Invention

This invention relates to projection printing systems
and, more particularly, to such a system having a pellicle
covering the mask and/or wafer. The systems according to the
invention are particularly adapted, among other possible uses,
for effecting the exposure of photoresist-coated semiconductor
wafers in the manufacture of integrated circuits.

This application is closely related to U.S. Patent
Application entitled "A Method of Fabricating a Pellicle Cover
for Projection Printing System", filed on even date herewith,
and bearing Attorney's Docket No. MI-3067, and U.S. Patent
Application entitled "A Method of Fabricating A Pellicle Cover
For Photomasks" filed on even date herewith, and bearing
Attorney's Docket NO. MI-3102.

### BACKGROUND OF THE INVENTION

Projection printing systems for forming an image on a
light sensitive substrate or wafer normally include a mask
having a transparent substrate with a pattern of opaque and
transparent areas formed on one surface thereof, an
illumination system for directing a beam of radiation energy such as light or UV rays through the mask to a radiation sensitive substrate or wafer, optical means for forming a focused image of the mask pattern on the radiation sensitive substrate and a pellicle cover for maintaining the images of any dirt particles on the surface of the mask out of focus. The pellicle cover is normally bonded to the substrate and completely covers the mask pattern. Such systems, for example, are described in U.S. Patents 4,063,812, 4,246,054 and 4,131,363 and in an article by Ron Hershel entitled: "Pellicle Protection of Integrated Circuits (IC) Masks", appearing in SPIE, vol. 275 Semiconductor Microlithography VI, (1981) page 23.

With increasing miniaturization, the pattern elements have become smaller and smaller to the extend that pattern resolution is limited by the wavelength of the light. This has led to the use of shorter wavelengths of the UV spectrum.

One disadvantage of the mask covers used heretofore is that they are only suitable for use in the range of from 4000 angstroms and above. Thus, an object of this invention is to provide a new and improved pellicle cover, which is suitable for use in the 2000 and 3000 angstroms range.

## SUMMARY OF THE INVENTION

The foregoing and other advantages of the mask covers of the invention, as compared to mask covers heretofore utilized for the above-stated purposes, will become apparent as the discussion proceeds. Briefly, in order to accomplish the desired results, the invention provides, in a projection printing system for forming an image on a radiation sensitive coated wafer which system includes a mask having a transparent substrate with a pattern of opaque and transparent areas formed on one surface thereof, an illuminating system for directing radiation through the mask to the radiation sensitive wafer, optical means for forming a focused image of the mask pattern on the wafer, the improvement comprising a pellicle cover for maintaining the images of any contaminate particles on the surface of the mask out of focus, said pellicle cover being fabricated from polymethylmethacrylate.

In one form of the invention, the illuminating system for directing radiation through the mask to the radiation sensitive coated wafer has a range of from about 2600 angstroms to about 4000 angstroms.

There has thus been broadly outlined the more important features of the invention in order that the detailed description thereof that follows may be better understood, and in order that the present contribution to the art may be better appreciated. There are, of course, additional features of the invention that will be described hereinafter and which will form the subject of the claims appended hereto. Those skilled in the art will appreciate that the conception upon which the disclosure is based may readily be utilized as a basis for the designing of other systems for carrying out the several purposes of the invention. It is important, therefore, that the claims be regarded as including such equivalent materials as do not depart from the spirit and scope of the invention.

A specific embodiment of the invention has been chosen for purposes of illustration and description, and is shown in the accompanying drawings, forming a part of this specification.

BRIEF DESCRIPTION OF THE DRAWINGS

Figure 1 is a schematic drawing of a projection printing system for forming an image on a radiation sensitive coated wafer constructed in accordance with the concepts of the present invention;

Figures 2 to 5 are side elevations showing the method steps involved for forming the pellicle cover assembly; and

Figures 6 to 9 are side elevations showing the series of steps involved in another method of fabricating the pellicle cover assembly.

## DETAILED DESCRIPTION OF THE INVENTION

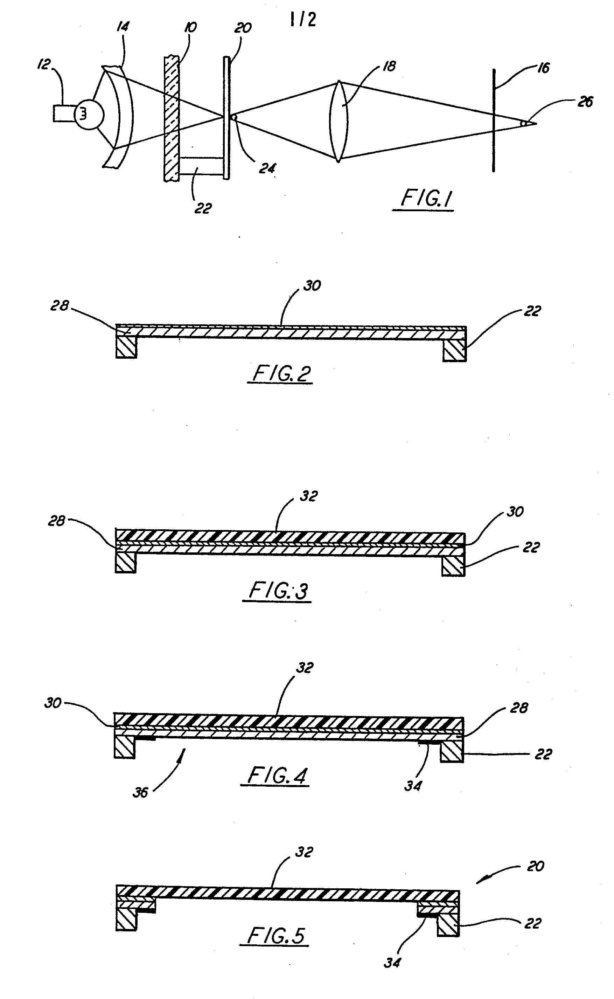

Referring to Figure 1, there is shown a projection printing system for forming an image on a radiation sensitive wafer, which comprises a mask 10 having a transparent substrate with a pattern of opaque and transparent areas formed on one surface thereof. An illuminating system is provided which includes a radiation source 12 and a condenser lens system 14 for directing radiation through the mask 10 to a radiation sensitive coated wafer member 16. An optical system 18 serves to form a focused image of the mask pattern on the wafer. A pellicle cover 20 is mounted on the mask 10, as by means of a support ring 22. As a result, scratching or particulate contaminates 24, which would otherwise rest on the mask surface, now rest on the surface of the pellicle and hence are focused out of the focal plane by thousands of times the depth of the field, as indicated at 26, Figure 1. Their shadows are dissipated over the imge field and have no effect on the resist image.

According to the present invention, the pellicle 20 is a thin polymer film. Polymethylmethacrylate (PMMA) has been found to be a particularly desirable material. Among other possible desirable parameters, PMMA has a high transmission in the range of from about 2400 angstroms to about 8000 angstroms, low light scattering, and thickness uniformity.

It is also rugged enough to be handled and cleaned without damage.

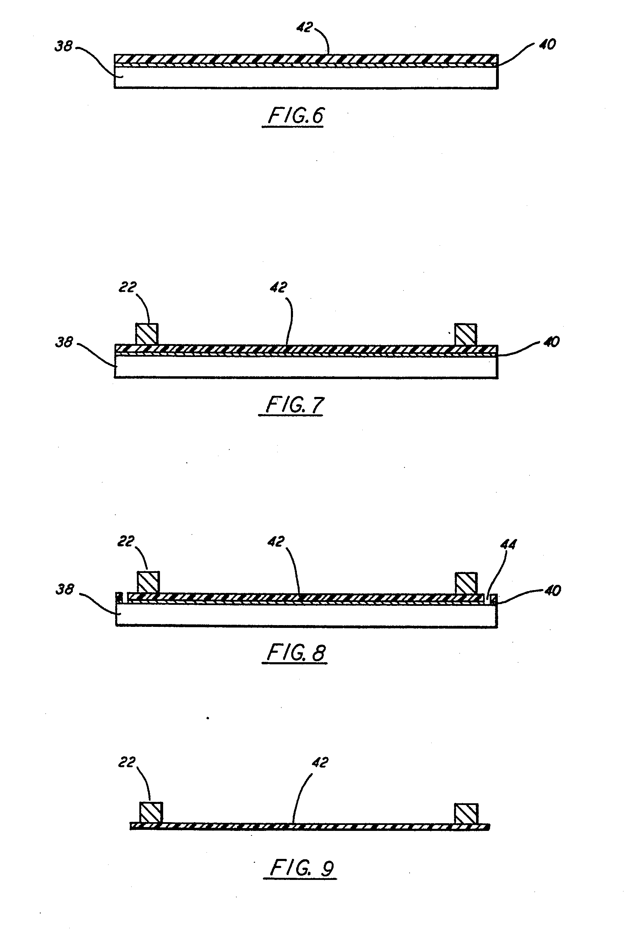

A method of fabricating a pellicle assembly from PMMA comprises the steps of taking a thin metal membrane, having a one micrometer titanium layer 28, Figure 2, and a 300 angstrom gold layer 30, and tensioning it and mounting it on the ring 22 to form a substrate. Referring to Figure 3, a thin polymer film of polymethylmethacrylate, (PMMA), 32 is then coated on the surface of the gold layer 30 in a uniform film using any suitable conventional technique such as spinning, for example. Then the PMMA polymer film 32 is cured. The back surface of the substrate, i.e., the exposed surface of the titanium 28 is then coated with photoresist 34. An aperture of the desired dimension is then defined in this photoresist by exposure and development, as indicated at 36 in Figure 4. After hard baking the photoresist 34, the titanium layer 28 is etched away using a solution of hydrogen fluoride and deionized water, 1 to 19, as shown in Figure 5. Immediately after rinsing in the deionized water, the gold layer 30 is etched away by a suitable conventional gold etching technique, leaving a free standing PMMA polymer membrane or cover as seen in Figure 5. The film thickness can be varied as desired from a few thousand angstroms to many microns.

Figures 6 to 8 illustrate a second method of fabricating the pellicle assembly. This method has certain advantages over the previously described method, because it is simpler, less expensive and allows for the use of standard equipment and some of the same techniques which are already in use in the semiconductor industry. The starting substrate is an oxidized silicon wafer 38, Figure 6, the size thereof being dependent on the required finished pellicle size. Onto the polished surface of this wafer, a 500 angstrom gold layer 40 is vacuum evaporated. A thin uniform PMMA polymer film 42 is coated onto the surface of the gold film, using suitable conventional spinning techniques. Thence, the polymer is cured, preferably at about 170°C. As seen in Figure 7, the next fabricating step comprises epoxying the pellicle support or mounting ring 22 onto the surface of the polymer layer 42. Then, with a razor blade or the like, a circular cut is made around the mounting ring 22, i.e., between the ring and the wafer edge, through the PMMA polymer layer 42 and gold film 40 so that the wafer surface is exposed, as indicated at 44, Figure 8.

The next step in the method is to carefully peel the ring off the wafer, resulting in a gold coated polymer membrane that is already mounted on a suitable pellicle ring. Then the gold is etched off by a suitable, conventional gold etching technique, such as, for example, by using potassium iodide, to produce the desired pellicle assembly as seen in Figure 9.

In some instances it may be desired to use a silicon wafer coated with chromium and then gold. In this case, after application and curing, the polymer membrane may be peeled directly off the gold surface, eliminating the gold etching step.

It will thus be seen that the present invention does indeed provide a new and improved pellicle assembly, which has a high transmission in the range of from about 2600 angstroms to about 8000 angstroms, low light scattering, and thickness uniformity, and which is rugged enough to be handled and cleaned without damage. Although a specific embodiment has been illustrated and described, it will be obvious to those skilled in the art that various modifications may be made without departing from the spirit and scope of the invention which is to be limited solely by the appended claims.

0118623

WHAT IS CLAIMED IS:

1. In a projection printing system for forming an image on a radiation sensitive coated wafer, which system includes a mask having a transparent substrate with a pattern of opaque and transparent areas formed on the surface thereof, an illuminating system for directing radiation through the mask to the radiation sensitive wafer, optical means for forming a focused image of the mask pattern on the wafer, the improvement comprising a pellicle cover assembly for maintaining the images of any contaminate particles on the surface of the mask out of focus, said pellicle cover being fabricated from polymethylmethacrylate.

2. Apparatus according to Claim 1 wherein said illuminating system for directing radiation through the mask to the radiation sensitive coated wafer has a range of from about 2600 angstroms to about 4000 angstroms.

0118623

FIG.1

FIG.2

FIG.3

FIG.4

FIG.5

38    42    40

*FIG.6*

22    42    40

38

*FIG.7*

22    42    44

38    40

*FIG.8*

22    42

*FIG.9*

European Patent Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | US-A-4 255 216 (J.W. CONANT)<br>* Column 2, lines 45-47 *<br><br>--- | 1,2 | G 03 F 1/00 |
| A | SOLID STATE TECHNOLOGY, vol. 25, no. 6, June 1982, pages 41-43, Port Washington, New York, USA R. WINN: "Pellicles - An industry overview"<br>* Whole article *<br><br>--- | 1,2 | |
| P,A | SOLID STATE TECHNOLOGY, May 1983, pages 135-143, Port Washington, New York, USA T.A. BRUNNER et al.: "Pellicle mask protection for 1:1 projection lithography"<br>* Whole article *<br><br>----- | 1,2 | |
| | | | TECHNICAL FIELDS SEARCHED (Int. Cl. ³)<br><br>G 03 F 1/00 |

The present search report has been drawn up for all claims

| Place of search | Date of completion of the search | Examiner |
|---|---|---|
| THE HAGUE | 05-06-1984 | RASSCHAERT A. |